# EUROPEAN PATENT APPLICATION

(11) **EP 4 800 401 A1**
(43) Date of publication of application: **02.09.2026**
(21) Application number: 25160782.6
(22) Date of filing: 28.02.2025
(51) Int. Cl.: G01R 15/20, H01F 38/30, G01R 19/00

(54) **CURRENT TRANSDUCER WITH A PRIMARY CONDUCTOR BAR**

(71) Applicant: LEM International SA, 1217 Meyrin (CH)
(72) Inventor: COUTELLIER, Damien, 01700 Miribel (FR); CABON, Fanny, 78380 Bougival (FR); SCHLÄFLI, Dominik, 1260 Nyon (CH)
(74) Representative: reuteler & cie SA

(57) **Abstract**

A current transducer (1) comprises a primary conductor bar (2), a magnetic field sensor (4), and a magnetic circuit core (14) comprising a U-shaped first core part (14a) and a U-shaped second core part (14b), each magnetic core part comprising an upper branch (15a) and a lower branch (15b) connected together by an end branch (15c). The primary conductor bar comprising a sensor orifice (5) extending through the primary conductor bar, the magnetic field sensor positioned in and extending through the sensor orifice, the magnetic field sensor having first and second spaced apart sensing elements (6a, 6b) with a measurement sensitivity direction (S) transverse to the general current flow direction (A). The first sensing element (6a) is positioned within the first airgap and the second sensing element (6b) is positioned within the second airgap.

## Description

The present invention relates to a current transducer.

Current sensors that are integrated into power modules used for energy conversion in electric vehicles, wind turbines, railway systems and other systems may typically comprise a primary conductor busbar for each electrical phase, with a magnetic field detector in the proximity of the primary conductor busbar to measure the intensity of the magnetic field generated by the current to be measured flowing in the conductor busbar. Such busbars often have a substantially rectangular cross-section.

It is known to have both coreless current transducers, as well as current transducers with magnetic circuit cores surrounding the primary conductor. The magnetic circuit core comprises an airgap with a magnetic field detector positioned in the airgap. Conventional current transducers with magnetic circuit cores are bulkier and heavier than coreless current transducers, however the magnetic circuit reduces the effects of external magnetic fields and increases measurement sensitivity for low amplitude currents. The bulkiness however poses a problem in many applications where compacity is important.

Moreover, in conventional current transducers with magnetic cores, one drawback may be the saturation of the magnetic core for high intensity currents that may limit the measurement range of the transducer. This can be reduced by splitting the magnetic core into two parts and having two airgaps within which respective first and second magnetic field sensors are positioned. The magnetic field sensors however have separate components that need to be interconnected to external circuitry, thus increasing the costs and complexity of the current transducer compared to coreless current transducers with or current transducers with a magnetic core and only one magnetic field sensor component.

In view of the foregoing, it is an object of the invention to provide a current transducer with a primary conductor bar that is compact, has a high measurement range, and low sensitivity to external stray magnetic fields.

It is advantageous to provide a current transducer that has a low weight.

It is advantageous to provide a current transducer that is economical to produce, yet robust and reliable.

It is advantageous to provide a current transducer that is economical to produce, yet accurate.

It is advantageous to provide a current transducer that is easy to integrate into external systems.

It is advantageous to provide a current transducer that has a high measurement accuracy and low error on a large measurement range, in particular having a sensitivity error of less than 5% for a kilo ampere measurement range, for instance a measurement ranges up to 2'000 amperes.

It is also advantageous to provide a current transducer with a high bandwidth, for instance up to 50 kilohertz or more.

Objects of the invention have been achieved by providing a current transducer according to claim 1.

Dependent claims set out various advantageous features of embodiments of the invention.

Disclosed herein is a current transducer comprising:
- a primary conductor bar,
- a magnetic field sensor, and
- a magnetic circuit core comprising a U-shaped first core part and a U-shaped second core part, each magnetic core part comprising an upper branch and a lower branch connected together by an end branch.

The primary conductor bar has a substantially rectangular cross-sectional profile with a sensor section having major surfaces that are substantially parallel to a primary conductor measurement centre plane, the sensor section extending in a general current flow direction, the primary conductor busbar having a first lateral edge and second lateral edge extending in the general current flow direction. The primary conductor bar comprises a sensor orifice extending through the primary conductor bar, the magnetic field sensor positioned in and extending through the sensor orifice. The magnetic field sensor has first and second spaced apart sensing elements with a measurement sensitivity direction transverse to the general current flow direction, the primary conductor bar comprises a first measurement section and a second measurement section on first and second sides of the sensor orifice respective, wherein the first and second measurement sections form respective first and second current flow paths in the general current flow direction.

The upper and lower branches of the first core part extend over the first measurement section and the upper and lower branches of the second core part extend over the second measurement section, whereby the opposed first and second core parts are spaced apart forming an upper airgap between free ends of the upper branches of the first and second core parts and a lower airgap between the lower branches of the first and second core parts, the first sensing element positioned within the first airgap and the second sensing element positioned within the second airgap.

In an advantageous embodiment, the primary conductor bar further comprises a first lateral slot extending from the first lateral edge in a transverse direction to the general current flow direction, wherein the end branch of the first core part is inserted at least partially in the first lateral slot.

In an advantageous embodiment, the primary conductor bar further comprises a second lateral slot extending from the second lateral edge in said transverse direction, wherein the end branch of the second core part is inserted at least partially in the second lateral slot.

In an advantageous embodiment, the end branch is positioned fully within the corresponding lateral slot.

In an advantageous embodiment, the opposed first and second core parts are arranged and dimensioned in mirror image symmetry.

In an advantageous embodiment, the current transducer further comprises an insulating housing surrounding at least the sensor section and comprising a sensor lodging cavity.

In an advantageous embodiment, the magnetic field sensor comprises at least one semiconductor die having at least first and second sensing elements having measurement sensitivity directions orthogonal to the semiconductor die. This would be the case for instance where the magnetic field sensor is a Hall effect sensor.

In an advantageous embodiment, the sensor orifice has a rectangular, oval, or oblong shape, a major axis of said rectangular, oval, or oblong shape arranged in the general current flow direction.

In a variant, for magnetic field sensors having measurement sensitivity directions parallel to the semiconductor die, for instance in tunnel magnetoresistance (TMR) sensors, the major axis of said rectangular, oval, or oblong shape may be arranged in a direction transverse to the general current flow direction.

In an advantageous embodiment, the magnetic field sensor is a Hall effect sensor.

In an advantageous embodiment, a height to width ratio of the substantially rectangular cross-sectional profile of the primary conductor bar 2 is in a range of 0.03 to 0.5 preferably in a range of 0.03 to 0.3.

In an advantageous embodiment, a thickness of the primary conductor bar is in a range from 0.5mm to 3mm and a width of the primary conductor bar is in a range from 10mm to 50mm.

In an advantageous embodiment, the magnetic circuit core parts are made from silicon iron or nickel iron.

In an advantageous embodiment, the upper branches of the magnetic core parts extend parallel at a distance of less than 5mm, preferably less than 4mm, for instance less than 3mm to an upper major surface of the primary conductor bar and the lower branches of the magnetic core parts extend parallel at a distance of less than 5mm, preferably less than 4mm, for instance less than 3mm to a lower major surface of the primary conductor bar.

Further advantageous features of the invention will be apparent from the following detailed description of embodiments of the invention and the accompanying illustrations.

### Brief description of the figures

Figure 1 is a schematic cross-sectional view of a current transducer according to an embodiment of this invention;
Figure 2 is a schematic perspective view of part of the embodiment of figure 1, in partial transparency and with a magnetic field sensor removed;
Figure 3a is a perspective view in partial transparency and with a magnetic field sensor removed of part of a current transducer according to another embodiment of this invention;
Figure 3b is a schematic cross-sectional view of the part of the current transducer of figure 3a;
Figure 4 is a perspective view of a primary conductor bar of a current transducer according to yet another embodiment of this invention.

Referring to the figures, a current transducer 1 according to embodiments of the invention comprises at least one electrical phase arrangement including a primary conductor bar 2, a magnetic circuit core 14, 14a, 14b a magnetic field sensor 4, and a housing 12.

The current transducer may include a polyphase arrangement (not shown), for instance a three-phase arrangement, in which case the current transducer comprises a plurality of primary conductor bars, one for each phase of the transducer, and a plurality of associated magnetic circuit cores and magnetic field sensors for each phase of the transducer.

The primary conductor bar 2 comprises connection ends 11a, 11b that may be in the form of terminals of various configurations for bolting, clamping, welding, solder or other forms of interconnection to conductors of a polyphase system through which the primary current to be measured flows. Although the connection ends 11 are schematically illustrated as straight sections, it may be noted that they may have various configurations, for instance bent out of the centre plane *P* in which the sensor section 7 extends, and comprise holes or have different shapes and extension directions for the different phases as required for coupling to an external polyphase system. The sensor sections 7 of the primary conductor bars 2 of each phase may however preferably be arranged in parallel and extend substantially in a general current flow direction *A.*

The primary conductor bar 2 comprises a substantially rectangular cross-sectional profile with the major surfaces parallel to a mid-plane *P* that forms a primary conductor measurement centre plane *P.* The primary conductor bar is bounded by lateral edges comprising a first lateral edge 3a and a second lateral edge 3b. The lateral edges may be substantially parallel.

Each primary conductor bar 2 comprises a sensor orifice 5 extending through the bar between the major surfaces within the sensor section 7. The sensor orifice is fully surrounded by material of the primary conductor bar. In other words the sensor orifices 5 are fully formed within the primary conductor bar without extending to a lateral edge.

The sensor orifice may have various shapes such as a square or circular shape, but preferably has a substantially rectangular shape, or an oblong shape configured to receive a magnetic field sensor 4 that extends through the sensor orifice and has sensing elements 6a, 6b that are positioned respectively below and above the primary conductor measurement centre plane *P.*

The magnetic field sensor 4 may comprise a Hall effect sensor or a tunnel magneto resistance (TMR) sensor, both these types of sensors being *per se* well known.

Magnetic field sensors of the afore-mentioned sort comprise sensing elements 6a, 6b formed in a semiconductor die encapsulated by an insulating overmold material and comprising sensor connection terminals 8 for electrical connection to a circuit board 18 for processing the measurement signals of the magnetic field sensor 4. The integrated circuit die of the magnetic field sensors extends in a direction that is orthogonal or substantially orthogonal to the primary conductor measurement plane *P,* each comprising sensing elements 6a, 6b that are spaced apart and positioned on respective sides of the primary conductor measurement centre plane *P.*

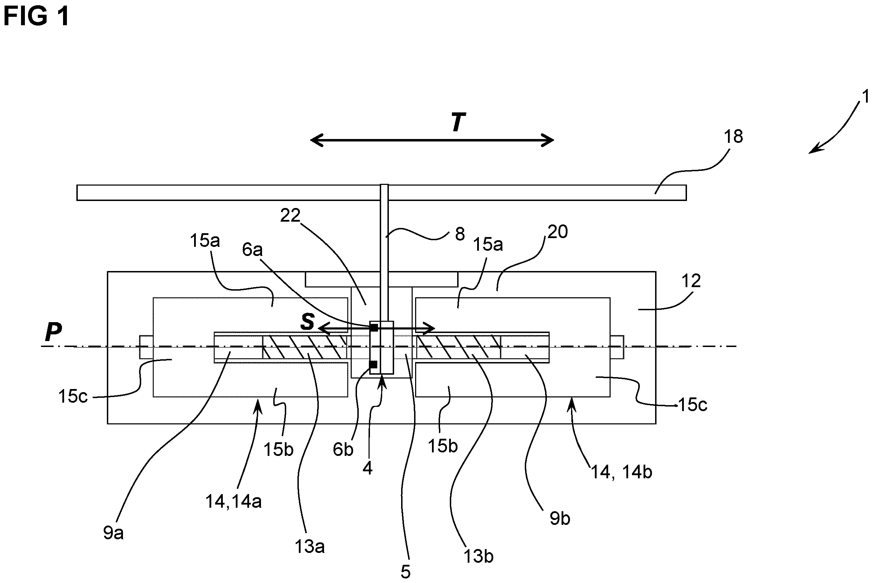

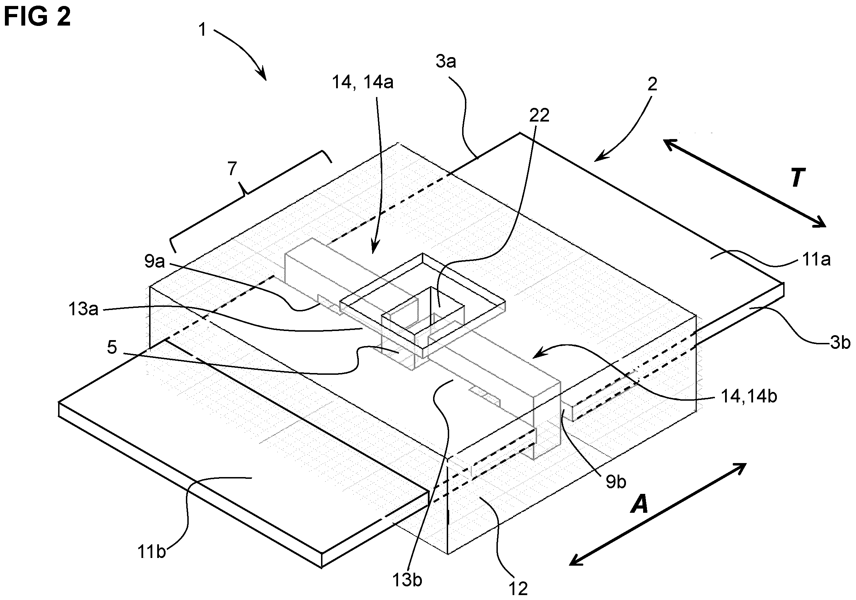

In a preferred embodiment, each primary conductor bar further comprises lateral slots 9 arranged on either side of the sensor orifice 5 (embodiment of figures 1 and 2), extending from opposite lateral edges, namely the first lateral slot 9a extends into the primary conductor bar material from the first lateral edge 3a and the second lateral slot 9b extends into the primary conductor bar material from the second lateral edge 3b.

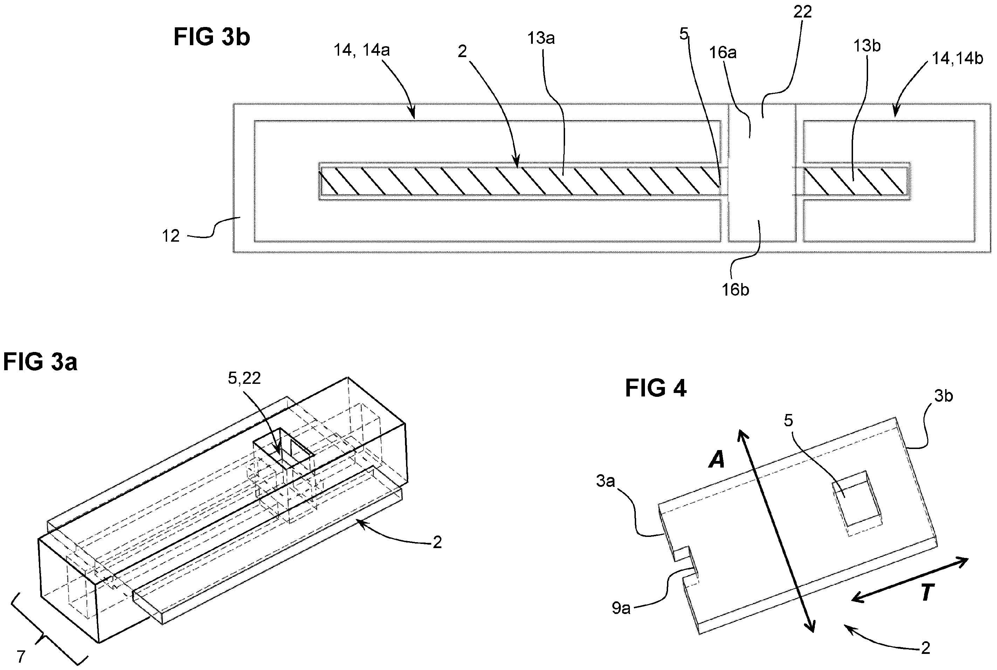

In a variant, there may be provided only one lateral slot extending from one lateral edge as illustrated in figure 4.

In other variants there may also be no lateral slots as illustrated in figures 3a, 3b.

The primary conductor current to be measured *l* flowing through the conductor bar 2 thus flows through the primary conductor bar material formed between the sensor orifice 5 and ends of the lateral slots (embodiment of figures 1 and 2), or lateral edge of the conductor bar (embodiment of figures 3a, 3b) such that the primary current is split into two partial currents *l*/2 that flow across either side of the sensor orifice 5 through the first measurement section 13a and second measurement section 13b in the general current flow direction A through the primary conductor. The narrow measurement sections 13a, 13b increase the current density locally and thus the also the density of the generated magnetic field around the measurement sections.

In an embodiment where the magnetic field sensor comprises with Hall sensors, the sensing direction ***S*** of the sensing elements 6a, 6b is orthogonal to the sensor die. In certain TMR or XMR magnetic field sensors the magnetic sensing direction ***S*** may be parallel to the sensor die.

In the illustrated embodiment of figures 1 and 2, which may include Hall effect magnetic field sensors, the sensor die is arranged parallel to the general current flow direction A and correspondingly, the sensor orifice 5, which has a substantially rectangular , oval or oblong shape, has its major axis arranged parallel to the general current flow direction *A.* The partial currents *l*/2 flowing on either side of the magnetic field sensor through the measurement sections 13a, 13b generates a magnetic field in the sensing elements 6a, 6b that is transverse *T* to the general current flow direction *A* and passes through the plane of the sensor die to be picked up by the sensing elements 6a, 6b. Since the two partial currents *l*/*2* are flowing substantially parallel to each other in a direction parallel to the general current direction *A,* the magnetic field on a first side of the primary conductor measurement centre plane *P* is in an opposite direction to the magnetic field on an opposite side of the primary conductor measurement centre plane *P.*

For sensor dies that have sensing elements 6a, 6b with a measurement sensitivity direction ***S*** that is parallel to the sensor die (not shown), for instance in tunnel magnetoresistance (TMR) sensors, the sensor dies may be oriented transversely *T* to the general current flow direction A.

The current transducer further comprises a magnetic circuit core 14 surrounding a portion of the sensor section 7 of the primary conductor bar 2.

The magnetic circuit core 14 comprises a first core part 14a and a second core part 14b forming therebetween two airgaps 16a, 16b.

In a preferred embodiment, the first core part 14a is inserted in the first lateral slot 9a and the second core part 14b is inserted in the second lateral slot 9b. Each magnetic core part 14a, 14b comprises an upper branch 15 and a lower branch 15b connected together by an end branch 15c such that each magnetic core part is substantially U-shaped.

The upper branch 15a and lower branch 15b are arranged on opposite sides with respect to the primary conductor measurement centre plane *P,* whereby the upper and lower branches are positioned adjacent respective major surfaces of the primary conductor bar, each of the branches extending over the respective measurement sections 13a, 13b.

The first core part 14a thus has its upper and lower branches extending over the first measurement section 13a and the second core part 14b has its upper and lower branches extending over the second measurement section 13b of the primary conductor bar.

The upper and lower branches extend to a free end, whereby the opposed first and second core parts are spaced apart and form airgaps 16, an upper airgap 16a formed between the free ends of the upper branches of the first and second core parts and a lower airgap 16b formed between the lower branches of the first and second core parts.

In a preferred embodiment the first and second core parts 14a, 14b are arranged in mirror image symmetry as illustrated in figures 1 and 2, but in variants the first and second core parts may be asymmetrical for instance as illustrated in figures 3a and 3b.

The end branch 15c of each core part, or at least of one of the two core parts, is preferably positioned at least partially within the corresponding lateral slot 9a, 9b, although in a variant as for instance illustrated in figures 3a and 3b with no lateral slots, the end branches are positioned around the outer lateral edges of the primary conductor bar.

In a preferred embodiment, the lateral slots and magnetic circuit core are dimensioned such that the end branches 15c of the respective magnetic core parts 14a, 14b are positioned fully within the respective lateral slots 9a, 9b such that the width of the primary conductor bar 2 in the transverse direction *T* is not increased by the magnetic circuit core, which thus remains within the width of the primary conductor bar.

The upper and lower branches of the primary conductor bar extend parallel to the upper and lower major surfaces of the primary conductor bar and are positioned adjacent and very close to, or even against or in contact with, the upper and lower major surfaces of the primary conductor bar, such that a low height current transducer may be provided despite the presence of the magnetic circuit parts. The distance between the branches and respective major surfaces of the primary conductor is less than 3mm, preferably less than 2mm, for instance less than 1mm.

The magnetic field sensor positioned within the sensor orifice 5 is mounted through the sensor orifice such that the first and second sensing elements 6a, 6b of the magnetic sensor are substantially symmetrically positioned about either side of the primary conductor measurement centre plane *P.*

The housing 12 may include an overmold portion 20 surrounding the measurement section and comprising a cavity 22 within the sensor orifice 5 of the primary conductor bar. The cavity 22 may be dimensioned to guide and accurately position the magnetic field sensor 4 within the sensor orifice 5 and the airgaps 16a, 16b.

The overmold portion may be separate from an outer casing of the housing, or may be integral with an overmold that forms the whole transducer housing and that may extend over adjacent primary conductor bars (not shown) of a polyphase current transducer.

The first sensing element 6a picks up principally the magnetic field passing through the upper airgap 16a on an upper side of the primary conductor bar, and the second sensing element 6b picks up principally the magnetic field through the lower airgap 16b.

It may be noted that the magnetic field generated by a current flowing through the measurement sections 13a, 13b generates a magnetic field in the upper airgap 16a which is an opposite direction to the magnetic field through the lower airgap 16b. The measurement sensitivity directions of the magnetic field sensor sensing elements 6a, 6b are aligned with the direction of the airgap, in other words aligned with a direction in which the magnetic field lines flow through the airgaps 6a, 6b.

Advantageously, the magnetic field sensor may for instance comprise a Hall effect sensor with at least one pair of sensing elements 6a, 6b. Hall effect sensors are per se well known.

In embodiments of the present invention, only a single a magnetic sensing component is required due to its positioning within the sensor orifice spanning across the measurement centre plane *P* of the primary conductor bar. The magnetic circuit core parts positioned within the lateral slots and adjacent the upper and lower major surfaces of the primary conductor bar, presenting airgaps that on the upper and lower sides proximate the sensor orifice, allow to provide a very compact transducer with a compacity similar to coreless transducers yet with magnetic core circuit parts that allow to increase measurement sensitivity and reject stray magnetic fields, while also avoiding problems of saturation of the magnetic core.

The sensor orifice through the primary conductor bar allows to insert sensing elements closer to the magnetic flux and to measure a high current density.

The magnetic field sensor extending through the measurement centre plane *P* and dual air-gap in the magnetic circuit core advantageously allows to
➢ amplify the magnetic flux to increase the signal measured by the sensing elements
➢ reduce impact of the mechanical displacement of the sensing elements in the air-gap, and
➢ provide good stray field rejection due to differential measurement and magnetic cores shielding effect

The transducer can be provided as a standalone component for assembly and connection to external circuits, or can be integrated directly inside a power module.

In an example of a typical application, the primary conductor bar thickness can vary from 0.5mm to 3mm (but not limited to this range) and have a width from 10mm to 40mm (but not limited to).

The magnetic circuit core parts may be made of a magnetic material preferably silicon iron (due to the intrinsic high saturation flux density) but other type of material such Nickel iron or ferrite can be used.

### List of references

Current transducer 1
   Primary conductor bar 2
      Lateral edges 3
         1^{st} lateral edge 3a
         2^{nd} lateral edge 3b
      Sensor orifice 5
      Sensor section 7
         1^{st} measurement section 13a
         2^{nd} measurement section 13b
      Lateral slots 9
         1^{st} lateral slot 9a
         2^{nd} lateral slot 9b
      Connection ends 11
         1^{st} connection end 11a
         2^{nd} connection end 11b
   Magnetic circuit core 14
      1^{st} core part 14a, 2^{nd} core part 14b
         Upper branch 15a
         Lower branch 15b
      Airgaps 16
         Upper airgap 16a
         Lower airgap 16b
   Magnetic field sensor 4
      Semiconductor die
      Sensing elements 6a, 6b
      Sensor connection terminals 8
   Transducer housing 12
      Sensor section overmold 20
      Sensor lodging cavity 22
   Circuit board 18
*Sensor direction of sensitivity S*
*General current flow direction A*
*Transverse current flow direction through the measurement sections T*
*Primary conductor measurement centre plane P*
*Sensing element offset from centre plane O*
*Magnetic field H*

## Claims

1. A current transducer (1) comprising :
- a primary conductor bar (2),
- a magnetic field sensor (4), and
- a magnetic circuit core (14) comprising a U-shaped first core part (14a) and a U-shaped second core part (14b), each magnetic core part comprising an upper branch (15a) and a lower branch (15b) connected together by an end branch (15c),
the primary conductor bar having a substantially rectangular cross-sectional profile with a sensor section (7) having major surfaces that are substantially parallel to a primary conductor measurement centre plane (*P*), the sensor section (7) extending in a general current flow direction (*A*),
the primary conductor busbar having a first lateral edge (3a) and second lateral edge (3b) extending in the general current flow direction (*A*),
the primary conductor bar comprising a sensor orifice (5) extending through the primary conductor bar, the magnetic field sensor positioned in and extending through the sensor orifice,
the magnetic field sensor having first and second spaced apart sensing elements (6a, 6b) with a measurement sensitivity direction (S) transverse to the general current flow direction (*A*),
the primary conductor bar comprises a first measurement section (13a) and a second measurement section (13a) on first and second sides of the sensor orifice respective, wherein the first and second measurement sections form respective first and second current flow paths in the general current flow direction,
and wherein the upper and lower branches of the first core part (14a) extend over the first measurement section (13a) and the upper and lower branches of the second core part (14b) extend over the second measurement section (13b), whereby the opposed first and second core parts are spaced apart forming an upper airgap (16a) between free ends of the upper branches of the first and second core parts and a lower airgap (16b) between the lower branches of the first and second core parts, the first sensing element (6a) positioned within the first airgap and the second sensing element (6b) positioned within the second airgap.

2. The current transducer of claim 1 wherein the primary conductor bar further comprises a first lateral slot (9a) extending from the first lateral edge (3a) in a transverse direction (*T*) to the general current flow direction (*A*), wherein the end branch (15c) of the first core part (14a) is inserted at least partially in the first lateral slot (9a).

3. The current transducer of the preceding claim 1 wherein the primary conductor bar further comprises a second lateral slot (9b) extending from the second lateral edge (3b) in said transverse direction (*T*), wherein the end branch (15c) of the second core part (14b) is inserted at least partially in the second lateral slot (9b).

4. The current transducer of either of the two directly preceding claims wherein the end branch is positioned fully within the corresponding lateral slot.

5. The current transducer of any preceding claim wherein the opposed first and second core parts are spaced apart and dimensioned in mirror image symmetry

6. The current transducer of any preceding claim further comprising an insulating housing (12) surrounding at least the sensor section (7) and comprising a sensor lodging cavity (22).

7. The current transducer of any preceding claim wherein the magnetic field sensor comprises at least one semiconductor die having at least first and second sensing elements having measurement sensitivity directions orthogonal to the semiconductor die.

8. The current transducer of the preceding claim wherein the sensor orifice has a rectangular, oval, or oblong shape, a major axis of said rectangular, oval, or oblong shape arranged in the general current flow direction (*A*).

9. The current transducer of any preceding claim wherein said magnetic field sensor is a Hall effect sensor.

10. The current transducer of any preceding claim 1-6 wherein the magnetic field sensor comprises at least one semiconductor die having at least first and second sensing elements having measurement sensitivity directions parallel to the semiconductor die and wherein the sensor orifice has a rectangular, oval, or oblong shape, a major axis of said rectangular, oval, or oblong shape arranged in a transverse direction (*T*) to the general current flow direction (*A*).

11. The current transducer of any preceding claim wherein a height to width ratio of the substantially rectangular cross-sectional profile of the primary conductor bar 2 is in a range of 0.03 to 0.5 preferably in a range of 0.03 to 0.3.

12. The current transducer of any preceding claim wherein a thickness of the primary conductor bar is in a range from 0.5mm to 3mm and a width of the primary conductor bar is in a range from 10mm to 50mm.

13. The current transducer of any preceding claim wherein the magnetic circuit core parts are made from silicon iron or nickel iron.

14. The current transducer of any preceding claim wherein the upper branches of the magnetic core parts extend parallel at a distance of less than 5mm, preferably less than 4mm, for instance less than 3mm to an upper major surface of the primary conductor bar and the lower branches of the magnetic core parts extend parallel at a distance of less than 5mm, preferably less than 4mm, for instance less than 3mm to a lower major surface of the primary conductor bar.
